# EUROPEAN PATENT APPLICATION

(11) **EP 4 113 604 A1**
(43) Date of publication of application: **04.01.2023**
(21) Application number: 22180893.4
(22) Date of filing: 24.06.2022
(51) Int. Cl.: H01L 25/065, H01L 23/66, H01L 25/00, H01L 23/00, H01L 23/482, H01L 25/07, H01L 27/088, H01L 29/08, H03F 3/19

(54) **SEMICONDUCTOR STRUCTURE AND MANUFACTURING METHOD THEREOF**

(30) Priority: 29.06.2021 CN 202110724211
(71) Applicant: United Microelectronics Corp., Hsinchu (TW)
(72) Inventor: VERMA, Purakh Raj, 757407 Singapore (SG); XING, Su, 510708 Singapore (SG)
(74) Representative: Becker, Eberhard

(57) **Abstract**

A semiconductor structure (10) including chips (100) is provided. The chips (100) are arranged in a stack. Each of the chips (100) includes a radio frequency (RF) device. Two adjacent chips (100) are bonded to each other. The RF devices (102) in the chips (100) are connected in parallel. Each of the RF devices (102) includes a gate (108), a source region (110), and a drain region (112). The gates (108) in the RF devices (102) connected in parallel have the same shape and the same size. The source regions (110) in the RF devices (102) connected in parallel have the same shape and the same size. The drain regions (112) in the RF devices (102) connected in parallel have the same shape and the same size.

## Description

### BACKGROUND

### Technical Field

The invention relates to a semiconductor structure and a manufacturing method thereof, and particularly relates to a semiconductor structure having a radio frequency (RF) device and a manufacturing method thereof.

### Description of Related Art

With the advancement of semiconductor technology, the semiconductor industry continues to shrink the size of the semiconductor device (e.g., RF device) to reduce the footprint of the device. However, how to further reduce the area of the RF device and improve the performance of the RF device is the goal of continuous efforts.

### SUMMARY

The invention provides a semiconductor structure and a manufacturing method thereof, which can reduce the area of the RF device and improve the performance of the RF device.

The invention provides a semiconductor structure, which includes chips. The chips are arranged in a stack. Each of the chips includes an RF device. Two adjacent chips are bonded to each other. The RF devices in the chips are connected in parallel. Each of the RF devices includes a gate, a source region, and a drain region. The gates in the RF devices connected in parallel have the same shape and the same size. The source regions in the RF devices connected in parallel have the same shape and the same size. The drain regions in the RF devices connected in parallel have the same shape and the same size.

According to an embodiment of the invention, in the semiconductor structure, the gates in the RF devices connected in parallel may be aligned with each other.

According to an embodiment of the invention, in the semiconductor structure, the source regions in the RF devices connected in parallel may be aligned with each other.

According to an embodiment of the invention, in the semiconductor structure, the drain regions in the RF devices connected in parallel may be aligned with each other.

According to an embodiment of the invention, in the semiconductor structure, each of the chips may further include a first bonding pad, a second bonding pad, and a third bonding pad. The first bonding pad is electrically connected to the gate. The second bonding pad is electrically connected to the source region. The third bonding pad is electrically connected to the drain region.

According to an embodiment of the invention, in the semiconductor structure, the first bonding pads between the two adjacent chips may be bonded to each other and have the same shape and the same size. The second bonding pads between the two adjacent chips may be bonded to each other and have the same shape and the same size. The third bonding pads between the two adjacent chips may be bonded to each other and have the same shape and the same size.

According to an embodiment of the invention, in the semiconductor structure, each of the RF devices may further include a body region. The body regions in the RF devices connected in parallel may have the same shape and the same size.

According to an embodiment of the invention, in the semiconductor structure, the body regions in the RF devices connected in parallel may be aligned with each other.

According to an embodiment of the invention, in the semiconductor structure, each of the chips may further include a bonding pad. The bonding pad is electrically connected to the body region.

According to an embodiment of the invention, in the semiconductor structure, the bonding pads between the two adjacent chips may be bonded to each other and have the same shape and the same size.

The invention provides another semiconductor structure, which includes chips. The chips are arranged in a stack. Each of the chips includes RF devices. Two adjacent chips are bonded to each other. The corresponding RF devices in the chips are connected in parallel to form RF device structures. The RF device structures are connected in series. Each of the RF devices includes a gate, a source region, and a drain region. The gates in the RF devices connected in parallel have the same shape and the same size. The source regions in the RF devices connected in parallel have the same shape and the same size. The drain regions in the RF devices connected in parallel have the same shape and the same size.

According to another embodiment of the invention, in the semiconductor structure, the gates in the RF devices on the same chip may have the same layout.

According to another embodiment of the invention, in the semiconductor structure, the gates in the RF devices on the same chip may have different layouts.

According to another embodiment of the invention, in the semiconductor structure, the source regions in the RF devices on the same chip may have the same layout.

According to another embodiment of the invention, in the semiconductor structure, the source regions in the RF devices on the same chip may have different layouts.

According to another embodiment of the invention, in the semiconductor structure, the drain regions in the RF devices on the same chip may have the same layout.

According to another embodiment of the invention, in the semiconductor structure, the drain regions in the RF devices on the same chip may have different layouts.

According to another embodiment of the invention, in the semiconductor structure, each of the RF devices may further include a body region. The body regions in the RF devices connected in parallel may have the same shape and the same size.

The invention provides a method of manufacturing a semiconductor structure, which include the following steps. Chips are bonded. The chips are arranged in a stack. Each of the chips includes an RF device. Two adjacent chips are bonded to each other. The RF devices in the chips are connected in parallel. Each of the RF devices includes a gate, a source region, and a drain region. The gates in the RF devices connected in parallel have the same shape and the same size. The source regions in the RF devices connected in parallel have the same shape and the same size. The drain regions in the RF devices connected in parallel have the same shape and the same size.

According to an embodiment of the invention, in the method of manufacturing the semiconductor structure, each of the RF devices may further include a body region. The body regions in the RF devices connected in parallel may have the same shape and the same size.

Based on the above description, in the semiconductor structure and the manufacturing method thereof according to the invention, the RF devices in the chips arranged in a stack are connected in parallel, the gates in the RF devices connected in parallel have the same shape and the same size, the source regions in the RF devices connected in parallel have the same shape and the same size, and the drain regions in the RF devices connected in parallel have the same shape and the same size. Therefore, the area of the RF device can be reduced and the performance of the RF device can be improved (e.g., increasing the operating speed, reducing the on-state resistance, or reducing the power loss).

In order to make the aforementioned and other objects, features and advantages of the invention comprehensible, several exemplary embodiments accompanied with figures are described in detail below.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principles of the invention.
FIG. 1A is an exploded schematic view illustrating a chip according to an embodiment of the invention.
FIG. 1B is a schematic view illustrating a semiconductor structure during chip bonding according to an embodiment of the invention.
FIG. 1C is a simplified view illustrating a semiconductor structure according to an embodiment of the invention.
FIG. 2 is a simplified view illustrating a semiconductor structure according to another embodiment of the invention.

### DESCRIPTION OF THE EMBODIMENTS

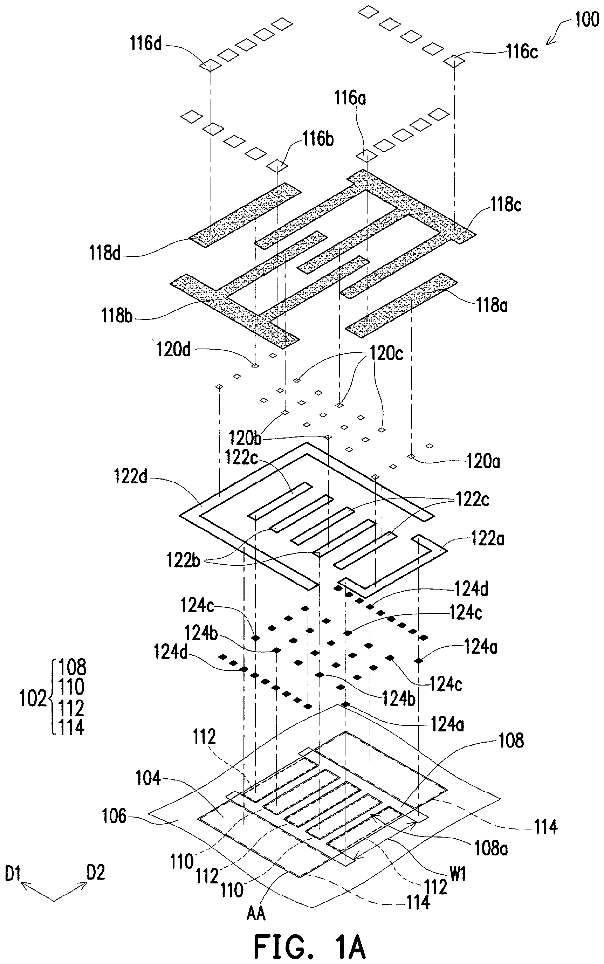

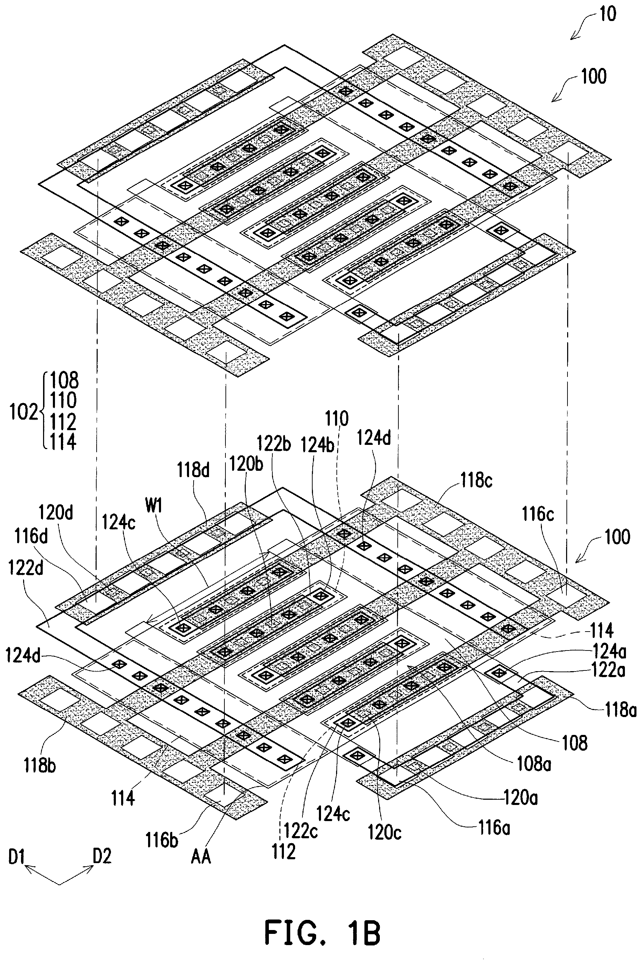

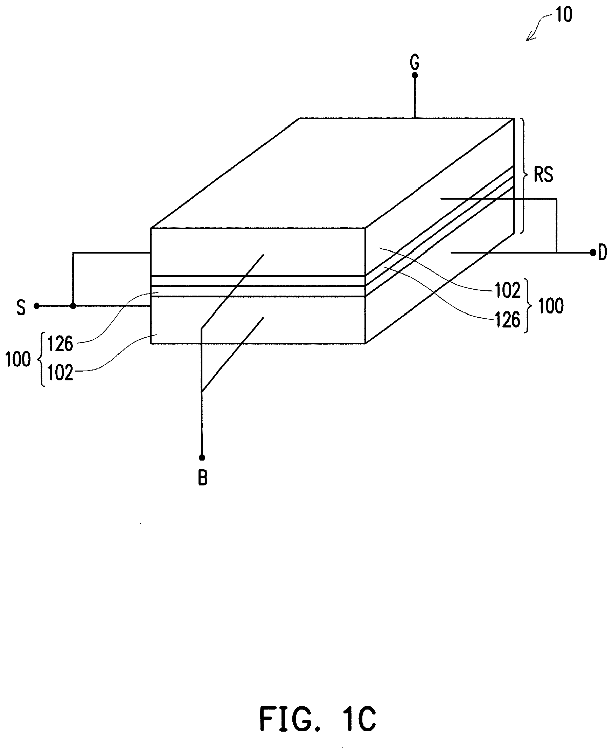

FIG. 1A is an exploded schematic view illustrating a chip according to an embodiment of the invention. FIG. 1B is a schematic view illustrating a semiconductor structure during chip bonding according to an embodiment of the invention. FIG. 1C is a simplified view illustrating a semiconductor structure according to an embodiment of the invention.

Referring to FIG. 1A, and FIG. 1B, the semiconductor structure 10 includes chips 100. The chips 100 are arranged in a stack. For example, the semiconductor structure 10 may include two chips 100 arranged in a stack, but the invention is not limited thereto. In addition, the stacking type of the chips 100 may be a wafer-on-wafer (WoW) type or a chip-on-chip (CoC) type.

Each of the chips 100 includes an RF device 102. The RF device 102 may be an RF switch, a low noise amplifier (LNA), or a power amplifier (PA). As shown in FIG. 1A, each of the chips 100 may further include a substrate 104. The RF device 102 is located on the substrate 104. The substrate 104 may be a semiconductor substrate such as a silicon substrate. Furthermore, there may be an isolation structure 106 in the substrate 104. The isolation structure 106 may define an active region AA in the substrate 104. The isolation structure 106 is, for example, a shallow trench isolation structure. The material of the isolation structure 106 is, for example, silicon oxide. In FIG. 1B, the substrate 104 and the isolation structure 106 in FIG. 1A are omitted to clearly describe the configuration relationship between the components in FIG. 1B.

Referring to FIG. 1A and FIG. 1B, each of the RF devices 102 includes a gate 108, a source region 110, and a drain region 112. The gate 108 is located on the substrate 104. In some embodiments, the gate 108 may have a finger portion 108a. Moreover, the shape of the gate 108 may be adjusted according to the requirement and is not limited to the shape shown in FIG. 1A and FIG. 1B. The material of the gate 108 is, for example, doped polysilicon. The source region 110 and the drain region 112 may be located in the active region AA. In addition, the source region 110 and the drain region 112 are located in the substrate 104 on two sides of the finger portion 108a of the gate 108. The source region 110 and the drain region 112 may be arranged along the direction D1. Furthermore, the finger portion 108a of the gate 108 has a finger width W1 in the direction D2. The direction D2 may intersect the direction D1. In some embodiments, the direction D2 may be perpendicular to the direction D1.

Moreover, each of the RF devices 102 may further include a body region 114. In some embodiments, the body region 114 may be located in the active region AA. In addition, the body region 114 may be located in the substrate 104 on two sides of the gate 108.

Furthermore, each of the chips 100 may further include at least one of a bonding pad 116a, a bonding pad 116b, a bonding pad 116c, a bonding pad 116d, a conductive line 118a, a conductive line 118b, a conductive line 118c, a conductive line 118d, a via 120a, a via 120b, a via 120c, a via 120d, a conductive line 122a, a conductive line 122b, a conductive line 122c, a conductive line 122d, a contact 124a, a contact 124b, a contact 124c, a and contact 124d. In some embodiments, the bonding pad 116a, the bonding pad 116b, the bonding pad 116c, and the bonding pad 116d may be direct bond interconnect vias (DBI vias), respectively.

The bonding pad 116a is electrically connected to the gate 108. For example, the bonding pad 116a may be electrically connected to the gate 108 by the conductive line 118a, the via 120a, the conductive line 122a, and the contact 124a, but the invention is not limited thereto. The bonding pad 116b is electrically connected to the source region 110. For example, the bonding pad 116b may be electrically connected to the source region 110 by the conductive line 118b, the via 120b, the conductive line 122b, and the contact 124b, but the invention is not limited thereto. The bonding pad 116c is electrically connected to the drain region 112. For example, the bonding pad 116c may be electrically connected to the drain region 112 by the conductive line 118c, the via 120c, the conductive line 122c, and the contact 124c, but the invention is not limited thereto. The bonding pad 116d is electrically connected to the body region 114. For example, the bonding pad 116d may be electrically connected to the body region 114 by the conductive line 118d, the via 120d, the conductive line 122d, and the contact 124d, but the invention is not limited thereto.

On the other hand, the bonding pad 116a, the bonding pad 116b, the bonding pad 116c, and the bonding pad 116d of the chip 100 may be located on the side of the chip 100 for bonding with another chip (e.g., another chip 100). In FIG. 1A and FIG. 1B, although only the bonding pad 116a, the bonding pad 116b, the bonding pad 116c, and the bonding pad 116d located on one side of the chip 100 are shown, the invention is not limited thereto. In other embodiments, if the bonding process is performed on two sides of the chip 100, the bonding pads may be disposed on two sides of the chip 100, and the bonding pads may be electrically connected to the corresponding terminals (e.g., gate, source region, drain region, or body region) by the appropriate interconnection structure.

Referring to FIG. 1C, each of the chips 100 may further include a dielectric layer 126. In FIG. 1A and FIG. 1B, the dielectric layer 126 in FIG. 1C is omitted to clearly describe the configuration relationship between the components in FIG. 1A and FIG. 1B. The dielectric layer 126 (FIG. 1C) is located on the substrate 100 (FIG. 1A) and exposes the bonding pad 116a, the bonding pad 116b, the bonding pad 116c, and the bonding pad 116d (FIG. 1B) to facilitate the bonding process. In some embodiments, the dielectric layer 126 may be a multilayer structure. The material of the dielectric layer 126 is, for example, silicon oxide, silicon nitride, silicon oxynitride, or a combination thereof.

Referring to FIG. 1B, two adjacent chips 100 are bonded to each other. That is, the method of manufacturing the semiconductor structure 10 includes bonding the chips 100. In some embodiments, two adjacent chips 100 may be bonded by a flip chip bonding method, but the invention is not limited thereto. In some embodiments, two adjacent chips 100 may be bonded by a hybrid bonding method.

For example, the bonding pads 116a between two adjacent chips 100 may be bonded to each other, so that the gates 108 in the stacked RF devices 102 may be electrically connected to each other. In addition, in some embodiments, the bonding pads 116a between two adjacent chips 100 may have the same shape and the same size and may be aligned with each other. In the present embodiment, "size" may refer to the length, width, or area of the component. The bonding pads 116b between two adjacent chips 100 may be bonded to each other, so that the source regions 110 in the stacked RF devices 102 may be electrically connected to each other. In some embodiments, the bonding pads 116b between two adjacent chips 100 may have the same shape and the same size and may be aligned with each other. The bonding pads 116c between two adjacent chips 100 may be bonded to each other, so that the drain regions 112 in the stacked RF devices 102 may be electrically connected to each other. In some embodiments, the bonding pads 116c between two adjacent chips 100 may have the same shape and the same size and may be aligned with each other. The bonding pads 116d between two adjacent chips 100 may be bonded to each other, so that the body regions 114 in the stacked RF devices 102 may be electrically connected to each other. In some embodiments, the bonding pads 116d between two adjacent chips 100 may have the same shape and the same size and may be aligned with each other.

Referring to FIG. 1B and FIG. 1C, the RF devices 102 in the chips 100 are connected in parallel. For example, the RF devices 102 in the chips 100 may be connected in parallel to form an RF device structure RS (FIG. 1C) by bonding the chips 100. The RF device structure RS may include a gate terminal G, a source terminal S, a drain terminal D, and a body terminal B. The gate terminal G is formed by electrically connecting the gates 108 in the stacked RF devices 102. The source terminal S is formed by electrically connecting the source regions 110 in the stacked RF devices 102. The drain terminal D is formed by electrically connecting the drain regions 112 in the stacked RF devices 102. The body terminal B is formed by electrically connecting the body regions 114 in the stacked RF devices 102.

Furthermore, the gates 108 in the RF devices 102 connected in parallel have the same shape and the same size. In some embodiments, the gates 108 in the RF devices 102 connected in parallel may be aligned with each other. The source regions 110 in the RF devices 102 connected in parallel have the same shape and the same size. In some embodiments, the source regions 110 in the RF devices 102 connected in parallel may be aligned with each other. The drain regions 112 in the RF devices 102 connected in parallel have the same shape and the same size. In some embodiments, the drain regions 112 in the RF devices 102 connected in parallel may be aligned with each other. The body regions 114 in the RF devices 102 connected in parallel may have the same shape and the same size. In some embodiments, the body regions 114 in the RF devices 102 connected in parallel may be aligned with each other.

In the present embodiment, the semiconductor structure 10 includes, for example, two chips 100 arranged in a stack, but the invention is not limited thereto. In other embodiments, the semiconductor structure 10 may include at least three chips 100 arranged in a stack. In addition, the semiconductor structure 10 may further include other required dielectric layers and other required interconnection structures according to the requirement, and the description thereof is omitted.

Based on the above embodiment, in the semiconductor structure 10 and the manufacturing method thereof, the RF devices 102 in the chips 100 arranged in a stack are connected in parallel, the gates 108 in the RF devices 102 connected in parallel have the same shape and the same size, the source regions 110 in the RF devices 102 connected in parallel have the same shape and the same size, and the drain regions 112 in the RF devices 102 connected in parallel have the same shape and the same size. Therefore, the area of the RF device 102 can be reduced and the performance of the RF device 102 can be improved.

For example, assuming that the finger portion of the gate of the traditional RF device has a finger width Wc, and the number of chips 100 arranged in a stack in the present embodiment is N (N is an integer greater than or equal to 2), then the finger width W1 of the finger portion 108a in the RF devices 102 connected in parallel can be one-Nth of the finger width Wc of the finger portion of the gate of the traditional RF device (i.e., Wl=Wc/N). Therefore, the gate 108 of the present embodiment can have a smaller size. In addition, the semiconductor structure 10 and the manufacturing method thereof of the present embodiment can reduce the size of the interconnect structure (e.g., conductive line) electrically connected to the RF device 102. In this way, the area of the RF device 102 can be reduced and the performance of the RF device 102 can be improved (e.g., increasing the operating speed, reducing the on-state resistance, or reducing the power loss).

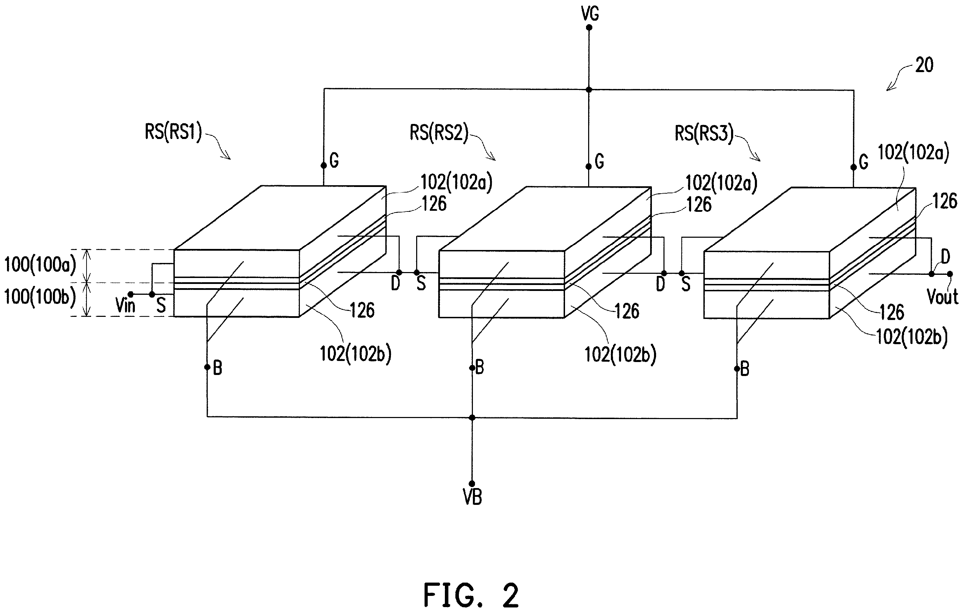

FIG. 2 is a simplified view illustrating a semiconductor structure according to another embodiment of the invention.

Referring to FIG. 1C and FIG. 2, the difference between the semiconductor structure 20 in FIG. 2 and the semiconductor structure 10 in FIG. 1C is as follows. In the semiconductor structure 20, each of the chips 100 includes a plurality of RF devices 102. In addition, after two adjacent chips 100 are bonded to each other, the corresponding RF devices 102 in the chips 100 are connected in parallel to form a plurality of RF device structures RS (e.g., RF device structure RS1, RF device structure RS2, and RF device structure RS3), and the RF device structures RS (e.g., RF device structure RS1, RF device structure RS2, and RF device structure RS3) are connected in series.

For example, the source terminal S in one (e.g., RF device structure RS2) of two adjacent RF device structures RS is electrically connected to the drain terminal D in the other (e.g., RF device structure RS1) of two adjacent RF device structures RS, the gate terminals G in the RF device structures RS are electrically connected to each other, and the body terminals B in the RF device structures RS are electrically connected to each other, so that the RF device structures RS are connected in series. Furthermore, the source terminal S of the RF device structure RS1 may be electrically connected to the voltage input terminal Vin, the drain terminal D of the RF device structure RS3 may be electrically connected to the voltage output terminal Vout, the gate terminals G of the RF device structures RS may be electrically connected to the gate voltage VG, and the body terminals B in the RF device structures RS may be electrically connected to the body voltage VB.

Furthermore, the RF device 102a in the RF device structure RS1, the RF device 102a in the RF device structure RS2, and the RF device 102a in the RF device structure RS3 may be located on the same chip 100a, and the RF device 102b in the structure RS1, the RF device 102b in the RF device structure RS2, and the RF device 102b in the RF device structure RS3 may be located on the same chip 100b.

In some embodiments, the gates 108 in the RF devices 102 on the same chip 100 may have the same layout. In other embodiments, the gates 108 in the RF devices 102 on the same chip 100 may have different layouts. In the present embodiment, "layout" may refer to the shape, area, and position of the component. In some embodiments, the source regions 110 in the RF devices 102 on the same chip 100 may have the same layout. In other embodiments, the source regions 110 in the RF devices 102 on the same chip 100 may have different layouts. In some embodiments, the drain regions 112 in the RF devices 102 on the same chip 100 may have the same layout. In other embodiments, the drain regions 112 in the RF devices 102 on the same chip 100 may have different layouts. In some embodiments, the body regions 114 in the RF devices 102 on the same chip 100 may have the same layout. In other embodiments, the body regions 114 in the RF devices 102 on the same chip 100 may have different layouts.

In the present embodiment, the semiconductor structure 20 includes, for example, three RF device structures RS, but the invention is not limited thereto. As long as the semiconductor structure 20 includes at least two RF device structures RS, it falls within the scope of the invention. In the present embodiment, the semiconductor structure 20 includes, for example, two chips 100 arranged in a stack, but the invention is not limited thereto. In other embodiments, the semiconductor structure 20 may include at least three chips 100 arranged in a stack.

Based on the above embodiment, in the semiconductor structure 20 and the manufacturing method thereof, the RF devices 102 in the chips 100 arranged in a stack are connected in parallel, the gates 108 in the RF devices 102 connected in parallel have the same shape and the same size, the source regions 110 in the RF devices 102 connected in parallel have the same shape and the same size, and the drain regions 112 in the RF devices 102 connected in parallel have the same shape and the same size. Therefore, the area of the RF device 102 can be reduced and the performance of the RF device 102 can be improved.

In summary, in the semiconductor structure and the manufacturing method thereof of the above embodiments, the RF devices in the chips arranged in a stack are connected in parallel, thereby reducing the area of the RF device and improving the performance of the RF device.

## Claims

1. A semiconductor structure (10), comprising chips (100), wherein
the chips (100) are arranged in a stack,
each of the chips (100) comprises a radio frequency (RF) device (102),
two adjacent chips (100) are bonded to each other,
the RF devices (102) in the chips (100) are connected in parallel,
each of the RF devices (102) comprises a gate (108), a source region (110), and a drain region (112),
the gates (108) in the RF devices (102) connected in parallel have the same shape and the same size,
the source regions (110) in the RF devices (102) connected in parallel have the same shape and the same size, and
the drain regions (112) in the RF devices (102) connected in parallel have the same shape and the same size.

2. The semiconductor structure (10) according to claim 1, wherein each of the chips (100) further comprises:
a first bonding pad (116a) electrically connected to the gate (108);
a second bonding pad (116b) electrically connected to the source region (110); and
a third bonding pad (116c) electrically connected to the drain region (112).

3. The semiconductor structure (10) according to claim 2, wherein
the first bonding pads (116a) between the two adjacent chips (100) are bonded to each other and have the same shape and the same size,
the second bonding pads (116b) between the two adjacent chips (100) are bonded to each other and have the same shape and the same size, and
the third bonding pads (116c) between the two adjacent chips (100) are bonded to each other and have the same shape and the same size.

4. The semiconductor structure (10) according to any one of claims 1 to 3, wherein each of the RF devices (102) further comprises a body region (114), and the body regions (114) in the RF devices (102) connected in parallel have the same shape and the same size.

5. The semiconductor structure (10) according to claim 4, wherein each of the chips (100) further comprises:
a bonding pad (116d) electrically connected to the body region (114).

6. A semiconductor structure (20), comprising chips (100, 100a, 100b), wherein
the chips (100, 100a, 100b) are arranged in a stack,
each of the chips (100, 100a, 100b) comprises RF devices (102, 102a, 102b),
two adjacent chips (100, 100a, 100b) are bonded to each other,
the corresponding RF devices (102, 102a, 102b) in the chips (100, 100a, 100b) are connected in parallel to form RF device structures (RS, RS1, RS2, RS3),
the RF device structures (RS, RS1, RS2, RS3) are connected in series,
each of the RF devices (102, 102a, 102b) comprises a gate (108), a source region (110), and a drain region (112),
the gates (108) in the RF devices (102, 102a, 102b) connected in parallel have the same shape and the same size,
the source regions (110) in the RF devices (102, 102a, 102b) connected in parallel have the same shape and the same size, and
the drain regions (112) in the RF devices (102, 102a, 102b) connected in parallel have the same shape and the same size.

7. The semiconductor structure (20) according to claim 6, wherein the gates (108) in the RF devices (102, 102a, 102b) on the same chip (100, 100a, 100b) have the same layout.

8. The semiconductor structure (20) according to claim 6, wherein the gates (108) in the RF devices (102, 102a, 102b) on the same chip (100, 100a, 100b) have different layouts.

9. The semiconductor structure (20) according to any one of claims 6 to 8, wherein the source regions (110) in the RF devices (102, 102a, 102b) on the same chip (100, 100a, 100b) have the same layout.

10. The semiconductor structure (20) according to any one of claims 6 to 8, wherein the source regions (110) in the RF devices (102, 102a, 102b) on the same chip (100, 100a, 100b) have different layouts.

11. The semiconductor structure (20) according to any one of claims 6 to 10, wherein the drain regions (112) in the RF devices (102, 102a, 102b) on the same chip (100, 100a, 100b) have the same layout.

12. The semiconductor structure (20) according to any one of claims 6 to 10, wherein the drain regions (112) in the RF devices (102, 102a, 102b) on the same chip (100, 100a, 100b) have different layouts.

13. The semiconductor structure (20) according to any one of claims 6 to 12, wherein each of the RF devices (102, 102a, 102b) further comprises a body region (114), and the body regions (114) in the RF devices (102, 102a, 102b) connected in parallel have the same shape and the same size.

14. A method of manufacturing a semiconductor structure (10), comprising:
bonding chips (100), wherein
the chips (100) are arranged in a stack,
each of the chips (100) comprises an RF device (102),
two adjacent chips (100) are bonded to each other,
the RF devices (102) in the chips (100) are connected in parallel,
each of the RF devices (102) comprises a gate (108), a source region (110), and a drain region (112),
the gates (108) in the RF devices (102) connected in parallel have the same shape and the same size,
the source regions (110) in the RF devices (102) connected in parallel have the same shape and the same size, and
the drain regions (112) in the RF devices (102) connected in parallel have the same shape and the same size.

15. The method of manufacturing the semiconductor structure (10) according to claim 14, wherein each of the RF devices (102) further comprises a body region (114), and the body regions (114) in the RF devices (102) connected in parallel have the same shape and the same size.
